(19) Europäisches Patentamt
European Patent Office
Office européen des brevets

(11) **EP 2 927 700 B1**

(12) **EUROPEAN PATENT SPECIFICATION**

(45) Date of publication and mention
of the grant of the patent:
**07.08.2019 Bulletin 2019/32**

(51) Int Cl.:
*G06F 17/18* (2006.01)          *G06F 17/50* (2006.01)
*G01R 19/25* (2006.01)

(21) Application number: **14163004.6**

(22) Date of filing: **01.04.2014**

(54) **Method for monitoring system variables of a distribution or transmission grid**

Verfahren zur Überwachung von Systemvariablen eines Verteilungs- oder Übertragungsgitters

Procédé pour système de surveillance des variables d'un réseau de distribution ou de transmission

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**07.10.2015 Bulletin 2015/41**

(73) Proprietor: **ABB Schweiz AG**
**5400 Baden (CH)**

(72) Inventors:
• **Jha, Rajeev Kumar**
**52074 Aachen (DE)**
• **Moser, Albert**
**52072 Aachen (DE)**
• **Kreusel, Jochen**
**68239 Mannheim (DE)**

(56) References cited:
**WO-A2-2013/089782     US-A1- 2006 129 367**

• **Roberto Mínguez ET AL: "Non Gaussian State Estimation in Power Systems", La Mancha, Spain, 30 June 2006 (2006-06-30), XP055138537, Retrieved from the Internet: URL:http://www.uclm.es/actividades0506/congresos/icmsm2006/articles/minguezch06.pdf [retrieved on 2014-09-05]**
• **WENG YANG ET AL: "Historical data-driven state estimation for electric power systems", 2013 IEEE INTERNATIONAL CONFERENCE ON SMART GRID COMMUNICATIONS (SMARTGRIDCOMM), IEEE, 21 October 2013 (2013-10-21), pages 97-102, XP032531968, DOI: 10.1109/SMARTGRIDCOMM.2013.6687940 [retrieved on 2013-12-18]**
• **BAPTISTA E C ET AL: "Logarithmic barrier-augmented Lagrangian function to the optimal power flow problem", INTERNATIONAL JOURNAL OF ELECTRICAL POWER & ENERGY SYSTEMS, JORDAN HILL, OXFORD, GB, vol. 27, no. 7, 1 September 2005 (2005-09-01), pages 528-532, XP027766994, ISSN: 0142-0615 [retrieved on 2005-09-01]**

EP 2 927 700 B1

**Description**

The invention relates to a method for monitoring a state of an energy distribution or transmission grid by monitoring system variables, wherein the system variables are estimated based on system equations reflecting the dynamic or static interdependency of the system variables of the grid and based on measurements taken for at least one of the system variables, and wherein the estimated system variables are visualized on a screen.

A transmission grid is commonly used to transport commodities such as electricity, gas, oil or water over long distances, from a location where the respective commodity is produced, to a distribution station which is located in the vicinity of respective consumers. From the distribution station, a corresponding distribution grid transports the commodity further to its various final destinations. Electricity, gas and oil are pure energy sources, while water is used in a much wider way. Even so, all four commodities will in the following be summarized under the term energy source or simply energy.

During the past years, energy transmission and distribution, in particular for electricity, has become more complex due to an increased spatial distribution of production sites and due to a more intermittent energy production, depending on the availability of for example renewable energy. Further, more and more actively controllable loads are introduced which may result in a high simultaneity of load reactions to a certain grid state. In addition, the energy demand is increasing worldwide, putting more pressure to grid operators to increase the efficiency of their respective grids. One of the ways to increase the efficiency is to increase the grid utilization factor, i.e. the relation between the total energy available and the energy demanded by the users, and to reduce the operating margins in the ratings of the technical equipment belonging to the grid.

The reduction of margins implies that the grid is going to be operated closer to its limits, and that the likelihood for it to hit these limits is going to be increased. Hence it is of utmost importance for a grid operator to be aware of the state of the grid in order to carry out remedial actions in time for avoiding a critical state, such as contingency analysis, load-shedding, or issuing of a request for immediate service or provision of additional energy from a different production site.

In order for the operator to get information on the current state of the grid, the obvious solution is to use online measurements which shall be presented to the operators preferably in close to real-time. However, these close to real-time measurements may be available at a comparatively large quantity in transmission grids, but in distribution grids they are not so common. In order to obtain the actual values of further system variables of the grid than available from measurements, it is known to apply state estimation techniques using available online measurements and guessed measurements, also called pseudo measurements, with the help of historical information based on system equations of the grid and certain statistical assumptions on measurement errors.

The term system variable refers to any time-varying or static variable describing the dynamic or static physical behavior of the energy source in the respective grid, e.g. for electricity this includes voltage, current, real power and reactive power; for fluids this includes temperature, pressure, volume and flow rate. Multiple system variables taken together may form a system state vector, also called grid state or system state. The values of the system variables are not known in advance, and the goal of the method presented here is to estimate the values of the system variables.
The term system equation refers to time-dependent or static equations which reflect the relation between different system variables. Accordingly, a set of system equations formulated for system variables of a grid forms a mathematical model of the dynamic and static behavior of the grid, also called grid model.

In addition to the problem of missing measurements for certain system variables, another issue may arise from the fact that measurements need to be telemetered, due to the spatial distribution of the respective grid equipment. The measurements are telemetered to a grid control system where they are then processed and visualized in a control room, i.e. at the operator's working place. Telemetry always includes a certain time delay and, more importantly, a certain risk for data transmission losses, so that the measurement data actually arriving in the control room cannot be assumed to be completely error-free. Accordingly, these measurements cannot be relied upon especially when taking operational decisions in a grid system with equipment having low marginal capacity. To deal with this latter problem, one of the existing ways is not to believe the measurement value as it is, but again to apply state estimation techniques for estimating a corresponding grid system variable which is close to the measurement and yet satisfies the fundamental grid equations, such as in the case of electricity Kirchoff's Voltage Law and Current Law.

In Kong et al.: "Advanced load modelling techniques for state estimation on distribution networks with multiple distributed generators", PSCC 2011, Stockholm, a method is presented for obtaining pseudo-measurements on the load side of an electricity distribution network to use in the well-known weighted least square based state estimation technique. The least square based state estimation minimizes the square of a measurement error vector. Inputs to the state estimation are the measurement values and the modeled variance of the measurements. For modeling the pseudo-measurements, i.e. the real and reactive load side power for which no measurements are available, probability density functions are determined from historical load data, using four different approaches: the method of assumed variance, the normal distribution fitting, the Gaussian Mixture Modelling and the correlation method. In order to be able to use the weighted least square estimator, which assumes a normal measurement error distribution, i.e. a Gaussian error distribution, for each of the probability density functions at least one variance is determined.

Further, *Kong* describes that so called equality constraints are taken into account by using Lagrange multiplier vectors. In general, equality constraints are known constraints in the physical behavior of some of the system variables which can be expressed by an equation. For example, in those grid nodes or grid buses where neither generators nor loads are connected, the corresponding sum of system variables for real and reactive power flowing into the node should at all times equal to zero. The system variables that are estimated in *Kong* are voltage magnitudes, voltage phase angles, real power and reactive power flow between different buses.

From Handschin et al.: "An interior point method for state estimation with current magnitude measurements and inequality constraints", PICA 1995, Salt Lake City, a state estimation algorithm is known which can handle current measurements in addition to power and voltage measurements and which takes into account not only equality constraints, but inequality constraints as well. Current measurements have the disadvantage that directional information is missing so that the sign of the corresponding real power and/or reactive power cannot be determined. By using inequality constraints, i.e. where the given constraints on the physical behavior of some of the system variables is expressed by corresponding inequalities, the missing directional information can be added to the state estimation. The criterion to be minimized in *Handschin* by the state estimation algorithm is again a weighted least square criterion.

In Minguez et al.: "Non Gaussian State Estimation in Power Systems", Int. Conf. on Mathematical and Statistical Modeling, La Mancha, Spain, June 2006, a power system state estimation method is proposed which uses a general weighted least square (WLS) state estimator that does not require the measurements to be either Gaussian or statistically independent. The WLS estimator is based on maximum likelihood estimation using statistical transformation. The statistical transformation is used to convert dependent and non-Gaussian measurement variables into independent and normally distributed variables, so that the likelihood estimation problem can be formulated as a weighted least square problem.

Further documents considering state estimation in a power system are Baptista et al.: "Logarithmic barrier-augmented Lagrangian function to the optimal power flow problem", Int. Journal of Electrical Power and Energy Systems, vol. 27 (2005), pp. 528-532; and Weng et al.: "Historical data-driven state estimation for electric power systems", IEEE SmartGridComm, Vancouver, Canada, October 2013, where the latter applies a Kalman-filter approach.

The inventors have now realized that the widely used weighted least square (WLS) algorithms are commonly based on certain assumptions which are not valid in today's distribution grids or networks, especially considering low voltage grids. Hence, these assumptions may worsen the overall estimation accuracy. Some of the assumptions which may not be valid in the context of state estimation for a distribution network are the assumptions that

- measurements have a Gaussian error distribution;
- power in the grid branches has a unidirectional flow since the distribution grid is operated radially or since in a low voltage grid, active power generally flows from a centralized conventional power generator to the load side.

The latter of these assumptions leads to the possibility for *Handschin* to explicitly determine the direction to a given current measurement before using it in the weighted least square state estimation formulation. However, in today's electricity distribution grids, power may flow in a bi-directional way since low voltage power generators, in particular belonging to photovoltaic installations, are included in the grids. For bidirectional power flow, the predetermined current direction may be incorrect.

Accordingly, it is an object of the present invention to provide a method for monitoring system variables of a distribution or transmission grid which is not based on the above listed assumptions but takes into account given conditions in today's electric power distribution grids.

This objective is achieved by a method as explained in the introduction, wherein the system variables are estimated by determining maximum log-likelihood estimates of the system variables based on minimizing an objective function which contains

- the system equations which take into account as system variables to be estimated at least all system variables for which corresponding measurements are available,
- for each of the system variables for which measurements are taken, a probability density function of the corresponding measurement error.

Accordingly, the method according to the invention does not use a weighted least square based state estimation technique, which is always based on the assumption that measurement errors have a Gaussian error distribution. Instead, the objective function to be minimized contains a term where the probability density function of measurement error can be entered directly for each of the measurements, i.e. each of the measured system variables. As a result, any form or type of probability density function for the measurement errors is considered in the state estimation, including both Gaussian and non-Gaussian error distributions. This is particularly useful for modeling the measurement errors in connection with measurements or pseudo-measurements of electrical medium-voltage and low-voltage loads, since analysis of historical data has revealed that their error distribution appears to fit more to either a beta error distribution or a lognormal error distribution.

Another aspect is the direct integration of all available measurements in the proposed method, i.e. the unknown system variable vector consists of not only voltage magnitude and phase angle as in conventional approaches, but allows for integrating all measured variables. Hence, the method directly estimates the measured variables, whereas conventional approaches first estimate the voltage magnitudes and phase angles at all buses and then calculate other system variables from the estimated results of voltages and angles. Accordingly, in the proposed method the bus voltages and phase angles are not the only unknown system variables to be estimated, as in conventional state estimation methods. The method gives the way to directly integrate any measured variable into the vector of unknown system variables. This helps for example in modelling current magnitude measurements in case of bi-directional power flow, so that no current direction needs to be determined beforehand, but is output of the state estimation.

As proposed, the objective function to be minimized contains a term containing the probability density functions of the measurement errors and at least one further term which contains the system equations. It is to be noted that the term with the probability density functions does not contain any system equations, i.e. it is free of any grid model. Instead, it consists only of a statistical modeling of the measurement errors. Opposed to that, in the existing approaches, in particular in the weighted least square estimation, the statistical model and the grid model are mixed. Due to the proposed separation of statistical model and grid model which becomes possible due to the integration of all measured system variables in the system variable vector to be estimated, it is now much easier to integrate the findings from statistical research on the true distribution of measurement errors in a particular grid, since the grid model remains unaffected of any changes in this respect.

By using the proposed method, the accuracy of the state estimation results is considerably improved over the known weighted least square estimation methods. This is in particular due to the fact that knowledge is used which is obtained from historical data on measurement error distributions. This knowledge is introduced in a maximum log-likelihood formulation of the estimation problem. The weighted least square estimation defines the minimization problem to be solved as finding the values for the system variables, i.e. the grid state at a certain point in time, which best correspond to the measurements taken at that certain point in time, i.e. for which the measurement errors would be minimum. Opposed to that, the proposed maximum log-likelihood estimation problem is formulated to find the grid state at a certain point in time which would most likely have produced the available measurements for that certain point in time, considering a given probability density function of measurement errors, a given range of some or all of the system variables and a given uncertainty of system equation parameters.

Another assumption that is made when using weighted least square estimation relates to the grid parameters. It is assumed that the parameters of the grid equipment, e.g. in case of an electricity grid the parameters resistance, inductance and capacitance, are constant and accurately known. However, it has been recognized that this supposition is not true, since grid parameters may vary over time.

It is proposed that the system equations may further take into account for at least one parameter of the system equations a corresponding predefined range of parameter values expressed as a parameter uncertainty.

Accordingly, the uncertainties can be specified explicitly thereby defining a value range for each of the uncertain parameters. In this way, temporary changes of the parameter values are taken into account, which may be due to changes in environmental conditions, such as temperature, humidity or pressure, or due to aging of the grid equipment, or even due to operational uncertainties, such as an unknown exact tap position of a transformer tap changer. The explicit consideration of parameter uncertainties results in an further increased accuracy of the state estimation.

It is further proposed that the system equations may take into account for at least one of the system variables a corresponding upper and/or lower value limit expressed by way of an inequality constraint. In this way the operating range or limits for the system variables are considered during the grid state estimation, leading to even more accurate results. The inequalities allow more information to be passed to the state estimation, for example it may be defined that the bus voltages must be within 90 -110% of their nominal value.

When the above approaches are combined in one and the same objective function to be minimized, as much knowledge on the behavior of the grid as is possible would be used directly for the state estimation, i.e. knowledge obtained from historical data or experience on measurement error distributions, on parameter uncertainties and on limits or constraints of state variables.

Advantageously, the system equations may further contain correlation relations between at least two of the system variables. In the known grid state estimation methods, it is assumed that measurements are independent from one another. However, this is not always correct. With the proposed method, it becomes now possible to take into account dependencies between measurements, i.e. between their corresponding system variables, as well as correlations among unmeasured system variables and between measured and unmeasured system variables. Accordingly, the correlation relations form an additional piece of knowledge which is introduced into the state estimation formulation, leading to even more correct estimation results.

This additional piece of knowledge may for example be applied in the following way. The system equations may take into account at least one measured system variable of at least one energy generator or load and the maximum log-likelihood estimates of system variables of further energy generators or loads are determined based on correlation relations to the at least one measured system variable. In this way, it becomes possible to introduce a system variable for each of the energy generators or loads, respectively, even if power is measured only once per grid node, which is often the case. In previous grid state estimation solutions, it was assumed that power was injected to or drawn from the grid only once per node. As a result, if both a generator and a load or if multiple generators and/or loads are connected to one and the same grid node, their respective power vectors were added in order to introduce the required only one resulting power vector into the state estimation. With the proposed method, the limitation of having only one power injection or consumption per node is now removed. Hence, more than one system variable may be introduced per node, up to having for each generator and load a corresponding own system variable or own set of system variables.

The objective function to be minimized by the proposed grid state estimation may be non-linear and may comprise

- in a first summand, a statistical model of the measurement errors in which statistical model takes into account the measurements, the corresponding probability density functions, the accuracy of the measurements and the system variables to be estimated,
- in a second summand, the system equations which take into account the parameter uncertainties and laws of the system,
- in a third summand, the equations which take into account the equality and/or inequality constraints corresponding to the range or limits put on the system variables,
- in a fourth summand, a first logarithmic barrier function for modeling a first difference between the system variables and their corresponding upper and/or lower value limit, and
- in a fifth summand, a second logarithmic barrier function for modeling a second difference between the actual grid parameters and their corresponding range boundaries

It is to be noted here that the second term or second summand consists of the system equations only and is free from measurements. In general, measurements cannot be assumed to be error free. Hence, writing the system equations to involve measurements would not be accurate. Instead in this method, the system equations are written in terms of system variables using uncertainty in parameters, which is the more accurate and better way to represent system laws.

The second and third summands of the objective function may be multiplied by corresponding Lagrange multipliers. Lagrange multipliers are a known concept for solving a constrained maximization or minimization problem.

The objective function to be minimized may accordingly be of the form

$$ J = -\ln\big(f(z, x, R)\big) - \lambda_h \cdot h(x, w_\epsilon, \epsilon) - \lambda_x \cdot g(x, w_l, l) - \mu \cdot \ln(w_\epsilon) - \mu \cdot \ln(w_l), $$

with

$f(z,x,R)$ being a vector of probability density functions of measurement errors for the measurements z;
$h(x, w_\epsilon, \epsilon)$ being a set of nodal and branch system equations including correlation relations, the system equations depending on $x$ as the system variable vector and
$w_\epsilon$ as a variable vector for uncertainty, with $\epsilon$ standing for predetermined uncertainty parameters;
$g(x, w_l, l)$ being a set of functions which depends on the system variables x and on a variable vector $w_l$ for state variable limits $l$ converted into constraints;
$\lambda_h, \lambda_x$ being Lagrange multipliers;
$\mu$ being a barrier term multiplier and
$ln$ standing for log-natural.

The objective function of the proposed method is minimized, i.e. the maximum log-likelihood estimates are determined by a data processing unit by preferably applying a pure Newton iteration using Jacobian and Hessian matrices.

The proposed method can be applied to any type of energy transmission or distribution grid, in particular to grids for transmitting or distributing electricity, gas, oil or water.

In case of an electricity grid, the unknown system variables contain at least voltage amplitudes and voltage phase angles at all grid nodes, at least one real and reactive power injection at all grid nodes which have at least one physical generator or load connected as well as real and reactive power flow in grid branches which are measured.

Advantageously, they may further contain branch currents. By including currents in the system variable vector, it becomes possible to provide a directly estimated solution also for those grid branches where no real or reactive power is measured. This is mostly the case in medium voltage or low voltage grids, opposed to power transmission grids where a considerable number of measurements are available for both real and reactive power.

For other grid types, the system variables may include pressure, temperature, volume, flow rate etc.

The invention and its embodiments will become even more apparent from the example and its embodiments described below in connection with the appended drawings which illustrate:

Fig. 1    a line diagram for a part of an electrical MV and LV distribution grid;
Fig. 2    an illustration of the lumped pi model for electrical series devices;
Fig. 3    an illustration of parameter uncertainty;
Fig. 4    an example for a Gaussian and a lognormal probability density function;
Fig. 5    an example for how the values of the grid state variables are presented on a screen.

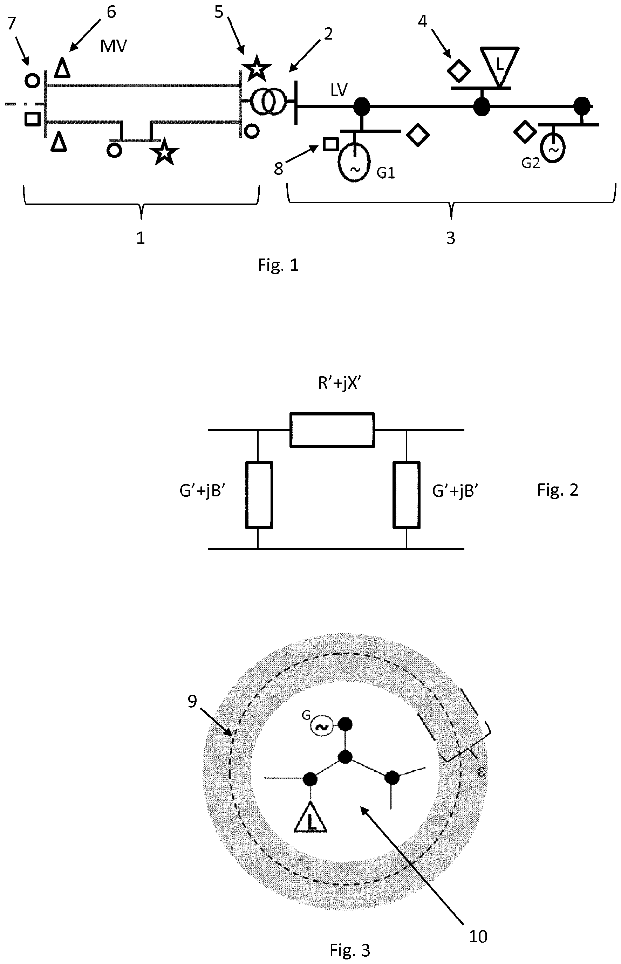

Fig. 1 shows a line diagram illustrating a part of a medium voltage (MV) distribution grid 1 which is connected via a transformer station 2 to a low voltage (LV) distribution grid 3. In the diagram, available measurements of some of the system variables of the MV or LV grid, respectively, are shown, each measured variable being identified by a different symbol. Current magnitude measurements 6 are indicated by a triangle; voltage amplitude measurements 7 are indicated by a circle; real and/or reactive power measurements 8 in connection with power generation, are referenced by a rectangle; real and/or reactive power measurements 5 in connection with power loads or power consumption, are illustrated by a star. With the diamond symbol, it is indicated for which busses a historical load profile 4 is available.

In order to be able to evaluate the state of the whole distribution grid, it would be advantageous for an operator to be able to get information on all interesting state variables of the grid, i.e. information on at least real and reactive power in all branches and voltage amplitude and phase angle at all nodes. However, as can be seen from Fig. 1, not all of these system variables are always measured and correctly known. Instead, for some branches current magnitude measurements are provided, and on the LV side, historical load profiles may be used as a source of information.

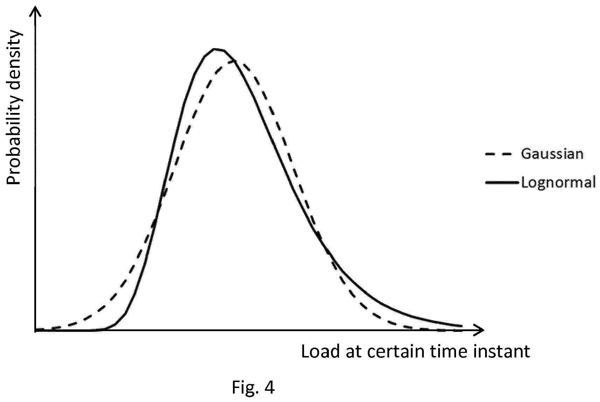

Starting from the available measurements and historical data profiles, in this example load profiles, it is proposed to determine the missing system variables by applying a state estimation technique which directly takes into account probability density functions of measurement errors. Measurement errors associated with telemetered data are generally assumed to be distributed normally (Gaussian). However, the historical data profiles which form the basis for determining the probability density functions associated with pseudo measurements, may in fact be of any type, Gaussian or non-Gaussian. In the example of Fig. 4, the distribution of the values for a LV load, i.e. LV power consumption, is shown with the corresponding probability density for each value, wherein the continuous line illustrates a log-normal distribution of the probability density, and the dashed line shows a Gaussian distribution. Recent research has revealed that typical LV loads fit more to the log-normal distribution than the Gaussian.

In the known weighted least square state estimation techniques, such non-Gaussian error distributions cannot be considered. This drawback is overcome with the proposed method, so that the estimation errors for state variables with a non-Gaussian measurement error distribution can be reduced.

In order to estimate system variables using state estimation technique, a grid model is required. The parameters of the grid model are commonly determined by applying the lumped element model technique to the devices and equipment of the grid. For an electrical grid, the lumped PI model as shown in Fig. 2 may be developed for series devices, e.g., lines and transformers. The line parameters accordingly become distributed resistance R' expressed in Ohms per unit length; distributed inductance X' expressed in Henries per unit length; distributed conductance G' of the dielectric material separating two line conductors and between conductor and earth, represented by a shunt resistor and expressed in Siemens per unit length; and the distributed capacitance B' between the two line conductors and between conductor and earth expressed in Farads per unit length.

As is illustrated by Fig. 3 for an example grid with one load L and one generator G, these line parameters are not known exactly, as indicated by a grey colored band of width ε, having a dashed circle 9 in the middle. The dashed circle 9 stands for the correctly known parameter values and ε represents a vector of uncertainties corresponding to the parameters.

In other words, the resistance R' of Fig. 2 is only known as $R' = R'_{corr} \pm \Delta R'$, with R'$_{corr}$ being the correct resistance value and $\Delta R'$ being the corresponding uncertainty ε_R.

For the whole grid, the parameter uncertainty may be expressed as $|C_{(\pi)}| \leq \varepsilon$.

In addition to taking into account the parameter uncertainties, limits to the system variables may be considered by the state estimation as well. The limits for a system variable vector x can be expressed as LL $\leq$ x $\leq$ UL, with LL being the lower limit vector and UL being the upper limit vector.

In order to be introduced into the state estimation method, the limits are converted into constraints using an additional pair of variables, resulting in $x - w_{xL} = LL$ and $x + w_{xU} = UL$ with $w_{xL}, w_{xU} \geq 0$.

This is done for each system variable having a limit and for each system equation with a parameter having an uncertainty, so that a vector $w_l$ is obtained for all the limits and a vector $w_\varepsilon$ for all the uncertainties.

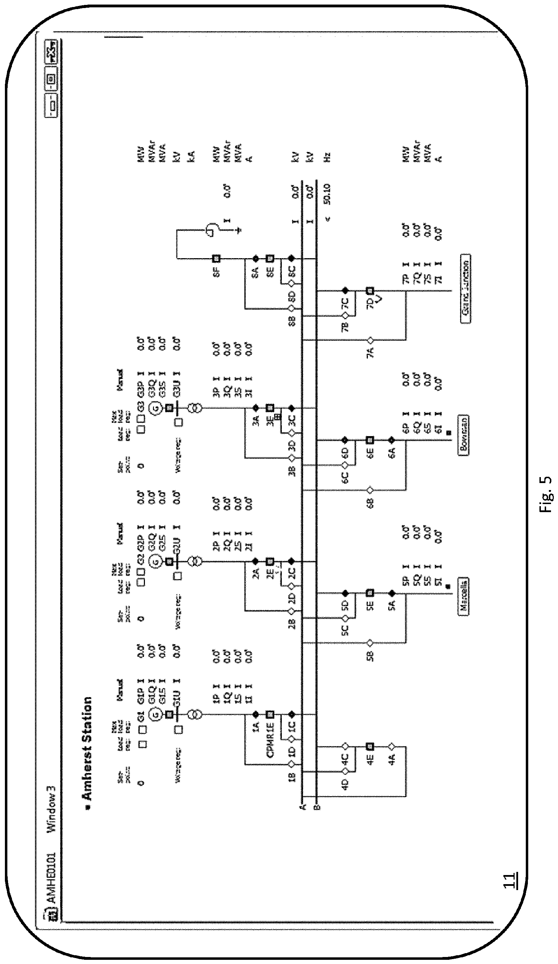

Once the probability density functions for the measurement errors and the grid model including the system variable limits and the parameter uncertainties are obtained, they are used together with measurements taken at a certain point in time in an objective function, where the objective function is to be minimized by a maximum log-likelihood algorithm. As a result, the system variables of the grid model are estimated for the certain point in time and are visualized on a screen 11, as illustrated for example by Fig. 5.

The screen is preferably located in a control room of a grid monitoring system and the proposed method is executed on a data processing device which receives the measurements via telemetry and either belongs to that control room and transmits the estimated results of system variables to be monitored directly to the screen, or is located outside the control room and transmits the results to that control room.

The state estimation method can be extended by further taking into account correlations between at least two of the system variables. In Fig. 1, two generators G1 and G2 are shown, where real and reactive power measurements are only taken for the first of the two generators, G1. By using correlation techniques, the value of the variables corresponding to real and reactive power of generator G2 can be directly estimated, wherein the correlation relations are modeled in the set of system equations $h(x, w_\varepsilon, \varepsilon)$.

**Claims**

1. Method for monitoring system variables of an energy distribution or transmission grid for electricity (10), wherein the system variables are estimated based on

   • system equations reflecting the dynamic and static behavior of the system variables of the grid, and
   • measurements ($z$) taken for at least one of the system variables,

   and wherein the estimated system variables are visualized on a screen,
   **characterized in that** the system variables are estimated by determining maximum log-likelihood estimates of the system variables based on minimizing an objective function ($J$) which contains

   • the system equations ($h$, $g$) which take into account as system variables to be estimated ($x$) at least all system variables for which corresponding measurements ($z$) are available, including voltage magnitudes and phase angles as well as current magnitude measurements,
   • wherein the system equations ($h$) further take into account for at least one parameter (R', X', G', B') of the system equations a corresponding predefined range of parameter values expressed as a parameter uncertainty ($\varepsilon$), in order to take into account temporary changes of parameter values of grid equipment which are due to changes in environmental conditions, due to aging of the grid equipment or due to operational uncertainties;
   • for each of the system variables for which measurements ($z$) are taken, a probability density function ($f(z,x, R)$) of the corresponding measurement error, wherein the term with the probability density functions does not contain any system equations and includes both Gaussian and non-Gaussian error distributions.

2. Method according to claim 1, wherein the system equations ($g$) further take into account for at least one of the system variables ($x$) a corresponding upper and/or lower value limit (LL, UL) expressed by way of an inequality constraint.

3. Method according to any of the previous claims, wherein the system equations ($h(x, w_\varepsilon, \varepsilon)$) contain correlation relations between at least two of the system variables.

4. Method according to claim 3, wherein the system equations take into account at least one measured system variable of at least one energy generator (G) or load (L) and wherein the maximum log-likelihood estimates of system variables of further energy generators or loads are determined based on correlation relations to the at least one measured system variable.

5. Method according to any of the previous claims, wherein the system equations contain at least one system variable for each physical location where energy is injected to or drawn from the grid.

**6.** Method according to any of the previous claims, wherein the probability density functions of measurement errors ($f(z,x,R)$) are of non-Gaussian type, in particular log-normal or beta, or of Gaussian type.

**7.** Method according to any of the previous claims, wherein the objective function to be minimized ($J$) is non-linear and comprises

- in a first summand, a statistical model of the measurement errors which statistical model takes into account the measurements ($z$), the corresponding probability density functions ($f(z,x,R)$), the function of accuracy of the measurements ($R$) and the system variables to be estimated ($x$),
- in a second summand, the state equations ($h(x, w_\varepsilon, \varepsilon)$) which take into account the parameter uncertainties ($\varepsilon$),
- in a third summand, the state equations ($g(x, w_l, l)$) which take into account the equality and/or inequality constraints ($w_l$) corresponding to the range/limit on system variable,
- in a fourth summand, a first logarithmic barrier function ($\mu \cdot \ln(w_l)$) for modeling a first difference between the actual system variables and their corresponding upper (UL) and/or lower value limit (LL), and
- in a fifth summand, a second logarithmic barrier function ($\mu \cdot \ln(w_\varepsilon)$) for modeling a second difference between the actual grid parameters and their corresponding range boundaries.

**8.** Method according to claim 7, wherein the second and third summands are multiplied by corresponding Lagrange multipliers ($\lambda_h, \lambda_x$).

**9.** Method according to any of the previous claims, wherein the maximum log-likelihood estimates are determined by applying a pure Newton iteration using Jacobian and Hessian matrices.

**10.** Method according to any of the previous claims, wherein the grid is an electricity grid and the system variables to be estimated contain voltage amplitudes and voltage phase angles at all grid nodes, at least one real and reactive power injection at all grid nodes which have at least one physical generator or load connected as well as real and reactive power flow in grid branches which are measured.

**11.** Method according to claim 10, wherein the system variables further contain branch currents.

**12.** Method according to any of the previous claims, wherein together with the estimated system variables other variables calculated based on the results of the system variables are visualized on the screen.

**Patentansprüche**

**1.** Verfahren zum Überwachen von Systemvariablen eines Energieverteilungsnetzes oder Übertragungsnetzes für Elektrizität (10), wobei die Systemvariablen auf folgender Grundlage geschätzt werden:

- Systemgleichungen, die das dynamische und statische Verhalten der Systemvariablen des Netzes widerspiegeln, und
- Messwerte ($z$), die für mindestens eine der Systemvariablen aufgenommen wurden, wobei

die geschätzten Systemvariablen auf einem Bildschirm visualisiert werden,
**dadurch gekennzeichnet, dass** die Systemvariablen durch Bestimmen maximaler logarithmischer Wahrscheinlichkeitsschätzungen der Systemvariablen auf der Grundlage eines Minimierens einer Zielfunktion ($J$), die Folgendes enthält, geschätzt werden:

- die Systemgleichungen ($h, g$), die als zu schätzende Systemvariablen ($x$) mindestens alle Systemvariablen berücksichtigen, für die entsprechende Messwerte ($z$) verfügbar sind, die Spannungsbeträge und Spannungsphasenwinkel sowie Strombetragsmesswerte enthalten, wobei
- die Systemgleichungen ($h$) ferner für mindestens einen Parameter (R', X', G', B') der Systemgleichungen einen entsprechenden vordefinierten Bereich von Parameterwerten, der als eine Parameterunsicherheit ($\varepsilon$) ausgedrückt wird, berücksichtigen, um vorübergehende Änderungen von Parameterwerten von Netzanlagen, die auf Änderungen in Umgebungsbedingungen aufgrund einer Alterung der Netzanlagen oder aufgrund von Betriebsunsicherheiten zurückgeführt werden, zu berücksichtigen; und
- für jede der Systemvariablen, für die Messwerte ($z$) aufgenommen werden, eine Wahrscheinlichkeitsdichtefunktion ($f(z,x,R)$) des entsprechenden Messfehlers, wobei der Ausdruck mit der Wahrscheinlichkeitsdichtefunktion keine Systemgleichungen enthält und sowohl Gaußsche als auch Nicht-Gaußsche Fehlerverteilungen enthält.

2. Verfahren nach Anspruch 1, wobei die Systemgleichungen ($g$) ferner für mindestens eine der Systemvariablen ($x$) eine entsprechende obere und/oder untere Wertgrenze (LL, UL), die in Form einer Ungleichheitsbedingung ausgedrückt wird, berücksichtigen.

3. Verfahren nach einem der vorhergehenden Ansprüche, wobei die Systemgleichungen ($h(x, w_\varepsilon, \varepsilon)$) Korrelationsbeziehungen zwischen mindestens zwei der Systemvariablen enthalten.

4. Verfahren nach Anspruch 3, wobei die Systemgleichungen mindestens eine gemessene Systemvariable mindestens eines Energieerzeugers (G) oder einer Last (L) berücksichtigen und die maximalen logarithmischen Wahrscheinlichkeitsschätzungen von Systemvariablen weiterer Energiegeneratoren oder Lasten auf der Grundlage von Korrelationsbeziehungen zu der mindestens einen gemessenen Systemvariable bestimmt werden.

5. Verfahren nach einem der vorhergehenden Ansprüche, wobei die Systemgleichungen mindestens eine Systemvariable für jeden physikalischen Ort, an dem Energie in das Netz eingespeist oder aus dem Netz entnommen wird, enthalten.

6. Verfahren nach einem der vorhergehenden Ansprüche, wobei die Wahrscheinlichkeitsdichtefunktionen von Messfehlern ($f(z,x,R)$) von einem nicht Gaußschen Typ, insbesondere logarithmisch-normal oder Beta, oder vom Gaußschen Typ sind.

7. Verfahren nach einem der vorhergehenden Ansprüche, wobei die zu minimierende Zielfunktion ($J$) nichtlinear ist und Folgendes umfasst:

   • in einem ersten Summanden ein statistisches Modell der Messfehler, wobei das statistische Modell die Messwerte ($z$), die entsprechenden Wahrscheinlichkeitsdichtefunktionen ($f(z,x,R)$), die Genauigkeitsfunktion der Messungen ($R$) und die zu schätzenden Systemvariablen ($x$) berücksichtigt,
   • in einem zweiten Summanden die Zustandsgleichungen ($h(x, w_\varepsilon, \varepsilon)$), die die Parameterunsicherheiten ($\varepsilon$) berücksichtigen,
   • in einem dritten Summanden die Zustandsgleichungen ($g(x, w_l, l)$), die Gleichheits- und/oder Ungleichheitsbedingungen ($w_l$), die dem Bereich/der Beschränkung einer Systemvariable entsprechen, berücksichtigen,
   • in einem vierten Summanden eine erste logarithmische Sperrfunktion ($\mu \cdot \ln(w_l)$), um eine erste Differenz zwischen den tatsächlichen Systemvariablen und ihrer entsprechenden oberen (UL) und/oder unteren Wertgrenze (LL) zu modellieren, und
   • in einem fünften Summanden eine zweite logarithmische Sperrfunktion ($\mu \cdot \ln(w_\varepsilon)$), um eine zweite Differenz zwischen den tatsächlichen Netzparametern und ihrer entsprechenden Bereichsgrenzen.

8. Verfahren nach Anspruch 7, wobei der zweite und der dritte Summand mit entsprechenden Lagrange-Multiplikatoren ($\lambda_h$, $\lambda_x$) multipliziert werden.

9. Verfahren nach einem der vorhergehenden Ansprüche, wobei die maximalen logarithmischen Wahrscheinlichkeitsschätzungen durch Anwenden einer reinen Newton-Iteration unter Verwendung von Jacobi- und Hess-Matrizen bestimmt werden.

10. Verfahren nach einem der vorhergehenden Ansprüche, wobei das Netz ein Elektrizitätsnetz ist und die zu schätzenden Systemvariablen Spannungsamplituden und Spannungsphasenwinkel bei allen Netzknoten, mindestens ein Wirkleistungs- und Blindleistungseinspeisung bei allen Netzknoten, mit denen mindestens ein physikalischer Generator oder eine Last verbunden ist, sowie den Wirkleistungs- und Blindleistungsfluss in Netzzweigen, die gemessen werden, enthalten.

11. Verfahren nach Anspruch 10, wobei die Systemvariablen ferner Zweigspannungen enthalten.

12. Verfahren nach einem der vorhergehenden Ansprüche, wobei zusammen mit den geschätzten Systemvariablen weitere Variablen, die auf der Grundlage der Ergebnisse der Systemvariablen berechnet werden, auf dem Bildschirm visualisiert werden.

**Revendications**

1. Procédé de surveillance de variables de système d'un réseau de distribution ou de transmission d'énergie destiné à fournir de l'électricité (10), dans lequel les variables de système sont estimées en fonction

   • d'équations de systèmes reflétant le comportement dynamique et statique des variables de système du réseau, et
   • de mesures ($z$) réalisées pour au moins une des variables de système,

   et dans lequel les variables de système estimées sont visualisées sur un écran,
   **caractérisé en ce que** les variables de système sont estimées en déterminant des estimations de probabilité logarithmique maximale des variables de système sur la base d'une minimisation d'une fonction objective ($J$) qui contient

   • les équations de système *(h, g)* qui tiennent compte comme variables de système à estimer ($x$) d'au moins toutes les variables de système pour lesquelles il existe des mesures correspondantes ($z$), y compris des grandeurs de tension et des angles de phase ainsi que des mesures de grandeur de courant,
   • dans lequel les équations de système ($h$) tiennent compte en outre pour au moins un paramètre (R', X', G', B') des équations de système d'une plage prédéfinie correspondante de valeurs paramétriques exprimée sous forme d'incertitude paramétrique ($\varepsilon$), afin de tenir compte de changements temporaires de valeurs paramétriques d'un équipement de réseau qui sont dus à des changements des conditions environnementales, à un vieillissement de l'équipement de réseau ou à des incertitudes opérationnelles ;
   • pour chacune des variables de système pour lesquelles des mesures ($z$) sont réalisées, une fonction de densité de probabilité *(f(z,x,R))* de l'erreur de mesure correspondante, dans lequel le terme avec les fonctions de densité de probabilité ne contient aucune équation de système et comporte des distributions d'erreur à la fois gaussienne et non gaussienne.

2. Procédé selon la revendication 1, dans lequel les équations de système *(g)* tiennent compte en outre pour au moins une des variables de système *(x)* d'une limite de valeur supérieure et/ou inférieure correspondante (LL, UL) exprimées au moyen d'une contrainte d'inégalité.

3. Procédé selon l'une quelconque des revendications précédentes, dans lequel les équations de système (*h(x, w$_\varepsilon$, ε)*) contiennent des relations de corrélation entre au moins deux des variables de système.

4. Procédé selon la revendication 3, dans lequel les équations de système tiennent compte d'au moins une variable de système mesurée d'au moins un générateur d'énergie (G) ou d'une charge (L) et dans lequel les estimations de probabilité logarithmique maximale de variables de système d'autres générateurs d'énergie ou charges sont déterminées en fonction de relations de corrélation avec l'au moins une variable de système mesurée.

5. Procédé selon l'une quelconque des revendications précédentes, dans lequel les équations de système contiennent au moins une variable de système pour chaque emplacement physique où une énergie est injectée dans le réseau ou tirée de celui-ci.

6. Procédé selon l'une quelconque des revendications précédentes, dans lequel les fonctions de densité de probabilité d'erreurs de mesures *(f(z,x,R))* sont du type non gaussien, en particulier log-normale ou bêta, ou du type gaussien.

7. Procédé selon l'une quelconque des revendications précédentes, dans lequel la fonction objective à minimiser (J) est non linéaire et comprend

   • dans un premier summand, un modèle statistique des erreurs de mesures qui tient compte des mesures ($z$), des fonctions de densité de probabilité correspondantes *(f(z,x,R))*, de la fonction de précision des mesures *(R)* et des variables à estimer ($x$),

   dans un deuxième summand, les équations d'état (*h(x, w$_\varepsilon$, ε)*) qui tiennent compte des incertitudes paramétriques ($\varepsilon$),

   • dans un troisième summand, les équations d'état *(g(x, w$_l$, l)* qui tiennent compte des contraintes d'égalité et/ou d'inégalité ($w_l$) correspondant à la plage/limite de la variable de système,
   • dans un quatrième summand, une première fonction barrière logarithmique ($\mu \cdot \ln(w_l)$) pour modéliser une

première différence entre les variables de système effectives et leur limite de valeur supérieure(UL) et/ou inférieure (LL) correspondantes, et

• dans un cinquième summand, une seconde fonction barrière logarithmique ($\mu\ ln(w_\varepsilon)$) pour modéliser une seconde différence entre les paramètres de réseau effectifs et leurs limites de plage correspondantes.

**8.** Procédé selon la revendication 7, dans lequel les deuxième et troisième summands sont multipliés par des multiplicateurs de Lagrange correspondants $(\lambda_h,\ \lambda_x)$.

**9.** Procédé selon l'une quelconque des revendications précédentes, dans lequel les estimations de probabilité logarithmique maximale sont déterminées en appliquant une itération de Newton pure utilisant des matrices jacobienne et hessienne.

**10.** Procédé selon l'une quelconque des revendications précédentes, dans lequel le réseau est un réseau électrique et les variables de système à estimer contiennent des amplitudes de tension et des angles de phase de tension au niveau de tous les noeuds du réseau, au moins une injection de puissance réelle et réactive au niveau de tous les noeud de réseau qui ont au moins un générateur ou une charge physique connectée ainsi qu'un flux de puissance réelle et réactive dans des branches de réseaux qui sont mesurées.

**11.** Procédé selon la revendication 10, dans lequel les variables de système contiennent en outre des courants de branches.

**12.** Procédé selon l'une quelconque des revendications précédentes, dans lequel outre les variables de système estimées d'autres variables calculées en fonction des résultats des variables de système sont visualisées sur l'écran.

Fig. 1

$$R'+jX'$$

$$G'+jB'$$ $$G'+jB'$$ Fig. 2

Fig. 3

Fig. 4

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **KONG et al.** Advanced load modelling techniques for state estimation on distribution networks with multiple distributed generators. *PSCC,* 2011
- **HANDSCHIN et al.** An interior point method for state estimation with current magnitude measurements and inequality constraints. *PICA,* 1995
- **MINGUEZ et al.** Non Gaussian State Estimation in Power Systems. *Int. Conf. on Mathematical and Statistical Modeling,* June 2006
- **BAPTISTA et al.** Logarithmic barrier-augmented Lagrangian function to the optimal power flow problem. *Int. Journal of Electrical Power and Energy Systems,* 2005, vol. 27, 528-532
- **WENG et al.** Historical data-driven state estimation for electric power systems. *IEEE SmartGridComm,* October 2013